# EUROPÄISCHE PATENTANMELDUNG

(11) **EP 2 023 420 A1**
(43) Veröffentlichungstag der Anmeldung: **11.02.2009**
(21) Anmeldenummer: 08157486.5
(22) Anmeldetag: 03.06.2008
(51) Int. Cl.: H01L 51/50

(54) **Strahlungsemittierende Vorrichtung**

(30) Priorität: 07.08.2007 DE 102007037097; 09.11.2007 DE 102007053396
(71) Anmelder: OSRAM Opto Semiconductors GmbH, 93055 Regensburg (DE)
(72) Erfinder: Mathai, Mathew K., Monroeville, 15146 (US); Choong, Vi-En, Carlsbad, CA 92009 (US); Choulis, Stelios A. Cyprus University of Technology, Office 33, PO Box 50329 3036, Lemesos (CY)
(74) Vertreter: Epping - Hermann - Fischer

(57) **Zusammenfassung**

Die Erfindung betrifft eine strahlungsemittierende Vorrichtung, umfassend eine erste Elektrode (1), die im Betrieb erste Ladungsträger mit einer ersten Ladung abgibt, eine erste ladungsträgertransportierende Schicht (3), die eine fluoreszierende Substanz (F) umfasst, eine zweite ladungsträgertransportierende Schicht (2), die eine phosphoreszierende Substanz (P) enthält,
eine zweite Elektrode (4), die im Betrieb zweite Ladungsträger mit einer zweiten Ladung abgibt,
wobei die zweite ladungsträgertransportierende Schicht (2) im Betrieb weitgehend frei ist von ersten Ladungsträgern.

## Beschreibung

Diese Patentanmeldung beansprucht die Prioritäten der deutschen Patentanmeldungen 10 2007 037 097.2 und 10 2007 053 396.0, deren Offenbarungsgehalte hiermit durch Rückbezug aufgenommen wird.

Es wird eine strahlungsemittierende Vorrichtung nach dem Oberbegriff des Anspruchs 1 angegeben.

Ein weit verbreitetes Problem von strahlungsemittierenden Vorrichtungen ist die geringe Ausbeute an emittierender Strahlung im Verhältnis zu der an die Vorrichtungen angelegten Spannung.

Eine Aufgabe von Ausführungsformen der Erfindung besteht darin, eine strahlungsemittierende Vorrichtung bereitzustellen, die eine erhöhte Ausbeute an emittierter Strahlung aufweist.

Die Aufgabe wir durch eine strahlungsemittierende Vorrichtung nach den Oberbegriffen des Anspruchs 1 gelöst. Weitere Ausführungsformen der strahlungsemittierenden Vorrichtung sind Gegenstand weiterer abhängiger Patentansprüche.

Eine Ausführungsform der Erfindung betrifft eine strahlungsemittierende Vorrichtung umfassend, eine erste Elektrode, die im Betrieb erste Ladungsträger mit einer ersten Ladung abgibt, eine erste ladungsträgertransportierende Schicht, die eine fluoreszierende Substanz umfasst und auf der ersten Elektrode angeordnet ist, eine zweite ladungsträgertransportierende Schicht, die eine phosphoreszierende Substanz enthält und auf der ersten ladungsträgertransportierenden Schicht angeordnet ist, eine zweite Elektrode, die zweite Ladungsträger mit einer zweiten Ladung im Betrieb abgibt und auf der zweiten ladungsträgertransportierenden Schicht angeordnet ist, wobei die zweite ladungsträgertransportierende Schicht im Betrieb der Vorrichtung weitgehend frei ist von ersten Ladungsträgern.

Bei einer strahlungsemittierenden Vorrichtung mit einer derartigen Schichtfolge ist die zweite ladungsträgertransportierende Schicht weitgehend frei von Ladungsträgern erster Ladung, welche von der ersten Elektrode im Betrieb abgegeben werden.

Dabei ist "weitgehend frei" so zu verstehen, dass die Ladungsträger erster Ladung in der zweiten ladungsträgertransportierenden Schicht während des Betriebs der Vorrichtung einen Anteil am Ladungstransport in dieser Schicht haben, der höchstens einen Anteil von 0,1 % am Gesamtladungstransport in dieser Schicht ausmacht. Dies kann zum Beispiel insbesondere bedeuten, dass der Unterschied zwischen dem durch die ersten Ladungsträger vermittelten Ladungstransport und dem durch die zweiten Ladungsträger vermittelten Ladungstransport wenigsten drei Zehnerpotenzen beträgt. Dies hat zur Folge, dass in dieser Schicht während des Betriebs der Vorrichtung fast nur zweite Ladungsträger wandern und damit praktisch keine Ladungsträger erster und zweiter Ladung aufeinandertreffen und rekombinieren können. Dadurch kann in dieser Schicht, in der sich eine phosphoreszierende Substanz befindet, keine Energie durch Rekombination der ersten und zweiten Ladungsträger freigesetzt werden, welche die phosphoreszierende Substanz in einen elektronisch angeregten Zustand anregen könnte. Die Energie zur Anregung der phosphoreszierenden Substanz muss somit aus der ersten ladungsträgertransportierenden Schicht in die zweite ladungsträgertransportierende Schicht transferiert werden.

Die zweite ladungsträgertransportierende Schicht kann unipolar sein und / oder Ladungsträger erster Ladung blockieren. Somit transportiert die zweite ladungsträgertransportierende Schicht während des Betriebs der Vorrichtung dann nur zweite Ladungsträger aber nicht oder nur im untergeordneten Maße erste Ladungsträger mit der Folge, dass die zweite ladungsträgertransportierende Schicht während des Betriebs der Vorrichtung weitgehend frei von ersten Ladungsträgern ist.

Eine Ausführungsform der Erfindung umfasst somit mindestens zwei Elektroden, zwischen denen mindestens zwei ladungsträgertransportierende Schichten angeordnet sind, von denen mindestens eine Schicht nur Ladungsträger zweiter Ladung transportiert, sowie mindestens eine weitere Schicht, in der Ladungsträger beider erster und zweiter Ladungen transportiert werden.

Treffen Ladungsträger erster Ladung und Ladungsträger zweiter Ladung, die entgegengesetzt geladen zur ersten Ladung ist, in der ersten ladungsträgertransportierenden Schicht aufeinander, so können diese unter Bildung von angeregten elektronischen Zuständen (Excitonen) rekombinieren. Das Exciton ist ein Zweiteilchenzustand aus angeregtem negativ geladenem Elektron und positiv geladenem Ladungsträger, dem so genannten "Loch" oder Defektelektron. Befindet sich ein Molekül im elektronisch angeregten Zustand, so gibt es mehrere Möglichkeiten die Energie über verschiedene Relaxationsprozesse wieder abzugeben. Bei der thermischen Relaxation wir die Energie als Wärmeenergie strahlungslos abgegeben. Eine weitere Möglichkeit ist eine Energieabgabe in Form von Strahlung, beispielsweise sichtbarer Strahlung im Bereich von etwa 400 bis 800 nm, sowie Strahlung im UV- und infraroten IR-Bereich. Hierbei unterscheidet man im Wesentlichen zwei Fälle: die Fluoreszenz und die Phosphoreszenz. Unter Fluoreszenz wird hier die Strahlungsabgabe durch die Relaxation aus einem elektronisch angeregten Singulettzustand verstanden, bei dem die Elektronen im angeregten Zustand gepaarte Elektronenspins aufweisen. Unter Phosphoreszenz wird hingegen ein Relaxationsprozess verstanden, bei dem die Relaxation aus einen elektronisch angeregten Triplettzustand erfolgt, bei dem die Elektronen im angeregten Zustand parallele Elektronenspins aufweisen.

Eine angeregte fluoreszierende Substanz kann somit Strahlung in Form von Fluoreszenz abstrahlen. Der Übergang von einem Singulett- in einen Triplettzustand ist aufgrund der damit verbundenen Spinnumkehr eigentlich verboten, da die Spinumkehr der quantenmechanischen Erhaltung des Spindrehimpulses widerspricht. Eine Spinnumkehr ist somit nur möglich, wenn die Änderung des Spin-Drehimpulses durch die Änderung eines anderen Drehimpulses kompensiert wird, was meist über den elektronischen Bahndrehimpuls erfolgt.

Bei der Rekombination von Elektron und "Loch" entsteht ein angeregter elektronischer Zustand, ein Exciton. Ein Exciton ist ein Zwei-Teilchen-Zustand, dessen Spin-1/2-Teilchen, Elektron und Loch, sich zu einem Gesamtspin 0, einem Singulett-Exciton, oder einem Gesamtspin 1, einem Triplett-Exciton, kombinieren können. Auf Grund der Spinstatistik bilden sich Singulett- und Triplett-Excitonen im Verhältnis 1:3.
Durch die Energie dieser Excitonen können fluoreszierende oder phosphoreszierende Substanzen in einen angeregten Zustand überführt werden. Aus dem dann wiederum eine Relaxation möglich ist, bei der die freiwerdende Energie in Form von zum Beispiel sichtbarer Strahlung abgegeben wird.

In der zweiten ladungsträgertransportierenden Schicht ist aufgrund der weitgehend fehlenden Ladungsträger erster Ladung praktisch kein Aufeinandertreffen von Ladungsträgern erster und zweiter Ladung möglich, und somit auch keine Rekombination der beiden Ladungsträger unter Bildung von Excitonen möglich. Die in dieser zweiten ladungsträgertransportierenden Schicht vorhandene phosphoreszierende Substanz, wird somit durch die Energie in einen angeregten Zustand versetzt, die von den Excitonen, bevorzugt den Triplett-Excitonen der ersten ladungsträgertransportierenden Schicht über Energietransfermechanismen in die zweite ladungsträgertransportierende Schicht transportiert wird.

Es ist erstrebenswert für eine Vorrichtung eine möglichst hohe Strahlungsausbeute zu erzielen, sowie die Möglichkeit zu haben, ein möglichst breites Strahlungsspektrum abdecken zu können. Eine gute Strahlungsausbeute bedeutet einen möglichst hohen Quotienten aus erhaltener Strahlungsausbeute im Verhältnis zu der an die erste und zweite Elektrode angelegten Spannung. Hierzu ist es erstrebungswert nicht nur die Energie in Strahlungsenergie umzuwandeln, die in angeregten elektronischen Singulettzustand vorhanden ist, sondern auch noch die Energie zur Strahlungserzeugung zu verwenden, welche in angeregten elektronischen Triplett-zuständen vorhanden ist. Letztere macht auf Grund der Spinstatistik 75% aus, da ein zweites Elektron in einem angeregten elektronischen Zustand drei unterschiedliche Orientierungsmöglichkeiten bezüglich des Spins eines ersten Elektrons einnehmen kann, die zu einem Triplettzustand führen, wohingegen nur eine Orientierungsmöglichkeit zur Spinpaarung und somit zum Singulettzustand führt. Der Versuch zusätzlich zu der Singulettemission auch noch einen größtmöglichen Teil der noch vorhandenen Energie in Triplettemission zu überführen wird auch als "triplet harvesting" bezeichnet. Dabei dient die phosphoreszierende Substanz dazu, die in den Triplett-Excitonen der fluoreszierenden Substanz vorhandenen angeregten elektronischen Zustände über Energietransfermechanismen aufzunehmen. Mittels strahlender Relaxation aus diesen Triplett-Excitonen der phosphoreszierenden Substanz wird dann die in den Triplett-Zuständen vorhandene Energie zur Strahlungsausbeute der strahlungsemittierenden Vorrichtung eingesetzt. Wäre die phosphoreszierende Substanz nicht in der strahlungsemittierenden Vorrichtung vorhanden, so würden die Triplett-Excitonen der fluoreszierenden Substanz über strahlungslose Quenchprozesse relaxieren mit der Folge, dass die in den Triplett-Excitonen der fluoreszierenden Substanz vorhandenen angeregten elektronischen Zustände nicht oder nur untergeordnet zur Strahlung der strahlungsemittierenden Vorrichtung beitragen.

Zwischen den Elektroden und den beiden ladungsträgertransportierenden Schichten, sowie den beiden ladungsträgertransportierenden Schichten selbst können weitere Schichten vorhanden sein.

So ist bei einer Ausführungsform der Erfindung zwischen der ersten ladungsträgertransportierenden Schicht und der zweiten ladungsträgertransportierenden Schicht eine unipolare ladungsträgertransportierende Schicht angeordnet, die die Ladungsträger erster Ladung blockiert oder nur Ladungsträger zweiter Ladung transportieren kann. Somit kann ein Eindringen von Ladungsträgern erster Ladung in die zweite ladungsträgertransportierende Schicht verhindert bzw. vermindert werden mit der Folge, dass die zweite ladungsträgertransportierende Schicht während des Betriebs der Vorrichtung weitgehend frei von Ladungsträgern erster Ladung ist. Die Energieniveaus der Matrix der zweiten ladungsträgertransportierenden Schicht müssen dabei nicht auf diesen Umstand hin ausgewählt sein.

Gemäß einer weiteren erfindungsgemäßen Ausführungsform verlaufen während des Betriebs der Vorrichtung Ladungsträgertransportpfade durch die strahlungsemittierende Vorrichtung. Unter Ladungsträgertransportpfaden versteht man im Zusammenhang mit dieser Erfindung, den Weg, den die Ladungsträger im Betrieb senkrecht zum Schichtenverlauf, also durch die Schichten hindurch von einer Elektrode kommend in Richtung der Elektrode der entgegengesetzten Ladung nehmen können. Für die Ladungsträger erster Ladung tritt dabei ein Ladungsträgertransportpfad auf, welcher durch den durch die erste Elektrode und die erste ladungsträgertransportierende Schicht begrenzten Bereich der Schichtenfolge der Vorrichtung vorgegeben ist. Für die Ladungsträger zweiter Ladung ergibt sich ein Ladungsträgertransportpfad, der ausgehend von der zweiten Elektrode zumindest durch die zweite ladungsträgertransportierende Schicht in die erste ladungsträgertransportierende Schicht reicht. Somit ist während des Betriebs der Vorrichtung der Ladungsträgertransportpfad für die ersten Ladungsträger kürzer als der Ladungsträgertransportpfad für die zweiten Ladungsträger.

Schichten, die zwischen den genannten Elektroden und den jeweils zu erreichenden ladungsträgertransportierenden Schichten liegen können von den entsprechenden Ladungsträgern während des Betriebs der Vorrichtung durchlaufen werden. So kann beispielsweise ein Ladungsträger erster Ladung eine excitonenblockende Schicht, welche sich zwischen der ersten Elektrode und der ersten ladungsträgertransportierenden Schicht befindet durchlaufen, was den Ladungsträgertransportpfad im Vergleich zu einer Schichtenfolge, bei der die excitonenblockende Schicht nicht vorhanden ist, entsprechend verlängert. Liegt die excitonenblockende Schicht zwischen der zweiten Elektrode und der zweiten ladungsträgertransportierenden Schicht, so kann sie während des Betriebs der Vorrichtung von den Ladungsträgern zweiter Ladung durchlaufen werden, wodurch sich der Ladungsträgertransportpfad der Ladungsträger zweiter Ladung entsprechend verlängern würde.

In einer weiteren Ausführungsform der Erfindung ist die strahlungsemittierende Vorrichtung beispielsweise eine organische Leuchtdiode (OLED) umfassend ein oder mehrere organische Schichten oder Schichten die organische Materialien enthalten. Bei den organischen Substanzen kann es sich beispielsweise um das Material der ersten ladungsträgertransportierenden Schicht und / oder zweiten ladungsträgertransportierenden Schicht handeln, sowie um die phosphoreszierende und / oder fluoreszierende Substanz. Weiterhin können auch die fluoreszierende und / oder phosphoreszierende Substanz ladungsträgertransportierende Eigenschaften aufweisen und somit die jeweiligen ladungsträgertransportierenden Schicht überwiegend aus diesen Substanzen bestehen oder sie als Basiskomponenten umfassen. Die fluoreszierende und / oder phosphoreszierende Substanz kann aber auch, unabhängig davon, ob diese organischer oder anorganischer Natur ist, als Dotierstoff in einem Matrixmaterial vorliegen. Wobei der Dotierstoff selbst zum Ladungstransport beitragen kann, aber nicht muss. Bei den organischen Substanzen kann es sich um polymere elektrolumineszierende Substanzen oder nicht-polymere Substanzen, sogenannte "small molecules" handeln. Wobei unter Elektrolumineszenz die Eigenschaft verstanden wird, dass eine Substanz durch Anlegen einer elektrischen Spannung zumindest teilweise zur Emission von Strahlung z. B. Licht angeregt werden kann.

Die OLED kann auf der Seite der ersten Elektrode wie auch auf der Seite der zweiten Elektrode ein Substrat aufweisen, auf dem der funktionelle Schichtstapel umfassend die ladungsträgertransportierenden Schichten angeordnet sein kann.

Bei einer weiteren erfindungsgemäßen Ausführungsform einer Vorrichtung kann die erste Elektrode eine Anode wie auch eine Kathode sein. Gleiches gilt auch für die zweite Elektrode, wobei die zweite Elektrode die umgekehrte Polarität der ersten Elektrode aufweist. Das heißt, handelt es sich bei der ersten Elektrode um eine Kathode, so ist die zweite Elektrode eine Anode. Ebenso besteht die Möglichkeit, dass die erste Elektrode eine Anode ist, und die zweite Elektrode eine Kathode.

Die Ladungsträger erster Ladung können somit negative Ladungsträger, Elektronen sein, wenn die erste Elektrode eine Kathode ist, wie auch positive Ladungsträger, sogenannte "Löcher", sein wenn die erste Elektrode eine Anode ist. Die Ladungsträger zweiter Ladung besitzen die entsprechende zu den Ladungsträgern erster Ladung entgegengesetzte Polarität. Das heißt, handelt es sich bei der zweiten Elektrode um eine Anode, so sind die Ladungsträger zweiter Ladung Löcher. Ebenso ist aber auch der ungekehrte Fall möglich, dass die Ladungsträger erster Ladung Löcher sind falls die erste Elektrode eine Anode ist, und die Ladungsträger zweiter Ladung Elektronen.

Umfasst eine erfindungsgemäße Ausführungsform der Erfindung eine Anode als erste Elektrode, dann handelt es sich bei den folgenden Schichten um eine lochtransportierende und elektronentransportierende Schicht als erste ladungsträgertransportierende Schicht,
eine elektronentransportierende Schicht als zweite ladungsträgertransportierende Schicht und eine Kathode als zweite Elektrode.

Umfasst eine erfindungsgemäße Ausführungsform der Erfindung eine Kathode als erste Elektrode, dann handelt es sich bei den folgenden Schichten um eine lochtransportierende und elektronentransportierende Schicht als erste ladungsträgertransportierende Schicht,
eine lochtransportierende Schicht als zweite ladungsträgertransportierende Schicht und eine Anode als zweite Elektrode.

In einer weiteren erfindungsgemäßen Ausführungsform kann die strahlungsemittierende Vorrichtung eine zweite Elektrode als Anode und eine erste Elektrode als Kathode umfassen. Auf die zweite Elektrode, die Anode, folgen eine Löcher induzierende Schicht (HIL), eine zweite ladungsträgertransportierende Schicht in Form einer löchertransportierenden Schicht (HTL) und eine erste ladungsträgertransportierende Schicht in Form einer elektronentransportierenden Schicht (ETL). Beim Anlegen des Durchlasspotentials injiziert die Anode positive Ladungsträger, sogenannte Löcher, und die Kathode Elektronen in die organischen Schichten. Die injizierten Löcher und Elektronen wandern jeweils zu den entgegengesetzt geladenen Elektroden. Bei Rekombination von Löchern mit Elektronen entstehen sogenannte angeregte elektronische Zustände, die Excitonen.

Durch die Energie dieser Excitonen können fluoreszierende oder phosphoreszierende Substanzen angeregt werden, welche dann Strahlung emittieren. Für die Emission von sichtbarer Strahlung stehen zwei Emissionswege zur Verfügung. Zum einen die Relaxation aus einem angeregten Singulettzustand, zum anderen die Relaxation aus einem angeregten Triplettzustand. Ein Triplettzustand zeichnet sich dadurch aus, dass die Elektronen des angeregten elektronischen Zustands einen gleichgerichteten Spin besitzen, wohingegen bei einem Singulettzustand die Elektronen des angeregten elektronischen Zustands einen entgegengesetzten Spin besitzen (die Spins sind "gepaart"). Zusätzlich können die angeregten Zustände aber auch über strahlungslose Quenchvorgänge ihre Energie abgeben, oder aber die abgegebene Strahlung liegt nicht im sichtbaren Bereich. In Zusammenhang mit dieser Erfindung wird der Begriff "Strahlung" unter der Bedeutung von elektromagnetischer Strahlung im Bereich von jeweils einschließlich IR bis UV genutzt. Um eine Emission in sichtbarem Bereich zu erzielen werden die unterschiedlichen Schichten einer OLED mit entsprechenden Substanzen dotiert, bzw. aus diesen gefertigt.

Bei der löchertransportierenden Schicht (HTL) sollte sowohl die Lage des höchsten besetzten Molekülorbitals (HOMOs) als auch der Abstand zwischen HOMO und den niedrigsten unbesetzten Molekülorbital (LUMO) an die Molekülorbitale HOMO/LUMO der anderen Schichten und Materialien der OLED angepasst sein. Das HOMO-Niveau muss niedrig genug sein, um die Löcher aus der Anode injizieren zu können. Andererseits darf es aber nur so tief liegen, dass die notwendige Energiebarriere zum HOMO der elektronentransportierenden Schicht (ETL) nicht zu groß ist, so dass die Löcher in der elektronentransportierenden Schicht wandern können um dort mit den Elektronen rekombinieren zu können. Soll hingegen keine Rekombination in der elektronentransportierenden Schicht stattfinden, also keine Löcher in diese Schicht gelangen, so muss das HOMO der HTL entsprechend tiefer als das der ETL gewählt werden. Hierdurch entstehend an dieser Stelle der OLED eine Lochsperre, d.h. eine löcherblockierende Schicht.

Der HOMO-LUMO-Abstand der HTL, wie auch anderer Schichten sollte ausreichend groß, größer als beim emittierenden Dopant, gewählt werden, damit die emittierte Strahlung nicht gleich wieder in der Schicht selbst absorbiert wird. Die Energiedifferenz zwischen LUMO-HTL und LUMO-ETL, muss danach gewählt werden, ob Elektronen in die HTL gelangen sollen oder nicht. Sollen keine Elektronen in die HTL gelangen, diese also als Elektronensperre dienen, so muss das LUMO der HTL energetisch über dem LUMO der ETL liegen. Das LUMO einer elektronenblockierenden Schicht sollte vorzugsweise mindestens 300 meV über dem der elektronentransportierenden Schicht liegen. Soll hingegen die Rekombination in der HTL stattfinden und die Elektronen in die HTL wandern können so muss die Energiedifferenz zwischen LUMO-HTL und LUMO-ETL klein gehalten werden. Die ETL sollte weiterhin eine LUMO besitzen, das tief genug liegt, damit die Elektronen aus der Kathode in besagtes LUMO injiziert werden können. Das Material der Kathode ist gegebenenfalls darauf abzustimmen. Umfasst die OLED auch eine löcherinjizierende Schicht (HIL), so sind die Energieniveaus an die der Anode und der HTL anzupassen, d.h. sie müssen zwischen den beiden liegen, was die Austrittsarbeit der Löcher von der Anode in die darauf folgende Schicht, hier die HIL, herabsetzt und somit den Lochübergang von Anode zur Folgeschicht erleichtert. Das HOMO der HIL sollte nicht mehr als 700 meV über dem der Anode liegen, bevorzugt nicht mehr als 500 meV.

Hat eine Schicht hingegen eine löcherblockierende Funktion, so muss ihr HOMO unter dem HOMO der Schicht liegen, aus der die Löcher fern gehalten werden sollen. Das HOMO der blockenden Schicht sollte hierbei mindestens 300 meV besser aber 700 meV unter dem der nachfolgenden Schicht liegen.

Eine Ausführungsform einer erfindungsgemäßen OLED kann auch eine excitonenblockierende Schicht umfassen. Eine solche wäre bevorzugt zwischen der zweiten ladungsträgertransportierenden Schicht und der zweiten Elektrode gelegen. Die Energieniveaus dieser Schicht müssen ebenfalls auf die der benachbarten Schichten abgestimmt werden. Dabei kommt es bei der excitonenblockierenden Schicht auf den Energieunterschied (ΔE) zwischen HOMO und LUMO an. Dieser definiert die Energie des Excitons. Ein Exciton kann somit nicht oder nur im untergeordneten Maße in eine Schicht diffundieren, deren ΔE um 100 meV, oder mehr, größer ist als die Energie des Excitons, bzw. das ΔE der Schicht, in der das Exciton gebildet wurde. Weiterhin kommt es darauf an, ob diese Schicht Elektronen oder Löcher leiten soll. Dementsprechend ist das Energieniveau des LUMOs bzw. HOMOs zu wählen. Sollen beispielsweise die Elektronen geblockt werden, so muss das LUMO der blockenden Schicht höher liegen, als das der Schicht in der die Elektronen zur blockenden Schicht hin transportiert werden.

Unabhängig von der Anwesenheit der ersten excitonenblockierenden Schicht kann bei weiteren Vorrichtungen auch eine zweite excitonenblockierende Schicht beispielsweise zwischen der ersten ladungsträgertransportierenden Schicht und der Schicht, welche die Ladungsträger erster Ladung in die erste ladungsträgertransportierende Schicht injiziert, vorhanden sein. Diese excitonenblockierende Schicht würde eine Diffusion der in der ersten ladungsträgertransportierenden Schicht gebildeten Excitonen in die injizierende Schicht unterbinden.

Platziert man aber eine excitonblockierende Schicht beispielsweise vor eine Kathode, so kann dadurch das Quenchen der Excitonen und das damit verbundene Überführen in strahlungslose Energie unterbunden werden.

Bei weiteren Ausführungsformen dieser Erfindung ist es möglich, die Energieniveaus der einzelnen Schichten aufeinander abzustimmen. Hierzu müssen entweder die Matrixmaterialen der ersten und zweiten ladungsträgertransportierenden Schichten oder die Dotierstoffe, welche in die Matrixmaterialien dieser Schichten eingebracht werden über entsprechende Energieniveaus verfügen. Die HOMO-(Highest Occupied Molecular Orbital) und LUMO-Niveaus (Lowest Unoccupied Molecular Orbital) der Substanzen können auf verschiedene Art und Weise bestimmt werden. Eine gängige Methode für die Bestimmung des HOMO-Niveau ist die Ultraviolet-Photoelektronen-Spektroskopie (UPS). Für die Bestimmung des LUMO-Niveaus eignet sich beispielsweise die inverse Photoemissionsspektroskopie (IPES). Die Energiedifferenz (ΔE) zwischen HOMO und LUMO kann direkt durch den Vergleich von Absorption- und Emissionsspektrum errechnet werden. Für die Funktionsweise der oben genannten Techniken sei auf die entsprechenden Lehrbücher verwiesen.

Um ein Quenchen des Phosphoreszenz-Dopanten als phosphoreszierende Substanz durch die Matrixsubstanz, in die dieser eingebracht wurde, zu vermindern bzw. zu vermeiden, sollte das Energie-Niveau des Dopanten aus dem die Phosphoreszenz erfolgt (T1-Niveau) unter dem T1-Niveau der Matrixsubstanz liegen. Liegt nämlich das T1-Niveau der Matrixsubstanz unter dem des Dopanten, so kann es zu einem strahlungslosen Triplett-Excitonen-Transfer vom Dopanten zur Matrix kommen. Auf Grund ihrer tief liegenden T1-Niveaus sind deshalb polymere Verbindungen, welche gute Ladungsträgertransporteigenschaften aufweisen, nur bedingt als Matrixmaterial für phosphoreszierende Dopanten geeignet. Je kleiner die Wellenlängen der vom Dopanten ausgestrahlten Strahlung ist, desto größer ist der Energieunterschied zwischen dem T1-Niveau und den energetischen Grundzustand. Das bedeutet, dass der Einsatz von Phosphoreszenz-Dopanten, welche im blauen Spektralbereich abstrahlen, auf Grund ihrer hochgelegenen T1-Niveaus schwieriger mit den T1-Niveaus möglicher Matrixmaterialien abstimmbar ist, als der Einsatz von phosphoreszierenden Dopanten, die im rotem Bereich emittieren.

Die vorliegende Vorrichtung löst das Problem der Energienievauanpassung durch die Kombination von fluoreszierenden Substanzen (Singulettemittern) und phosphoreszierenden Substanzen (Triplettemittern) in unterschiedlichen Schichten, d.h. in unterschiedlichen Schichten, die unterschiedliche Matrixsubstanzen aufweisen können. Analoges gilt auch für das Energieniveau des Fluoreszenz-Dopanten aus dem die Fluoreszenz erfolgt (S1-Niveau) und das entsprechende S1-Niveau der Matrix, sofern die Matrix nicht selbst als Emitter fungiert.

Enthält die Ausführungsform einer Vorrichtung mehr als nur eine mit phosphoreszierenden Dopanten versehene Schicht, so ist auf die Abfolge dieser Schichten zu achten. Die Schicht, mit dem phosphoreszierenden Dopanten, der das niedrigste T1-Niveau besitzt, sollte am weitesten weg von der Schicht sein, in der die Excitonen gebildet werden, also als letzte der Schichten mit phosphoreszierenden Substanz von den Triplettexcitonen durchlaufen werden. Es sei den, dass die Energieübertragung vom Matrixmaterial zum Dopanten aufgrund der Lage der Energieniveaus der angeregten Zustände in dieser Schicht deutlich schlechter und ineffizienter ist als bei den anderen Schichten mit anderen Matrix-Dopant-Kombinationen, dann wiederum sollte diese Schicht in der Schichtfolge der Vorrichtung wieder näher an der ersten ladungsträgertransportierenden Schicht liegen, in der die Excitonen gebildet werden, um eine möglichst gute Strahlungsausbeute zu erzielen.

In einer Ausführungsform kann die phosphoreszierende Substanz als Dopant in einem ladungsträgertransportierenden Matrixmaterial vorhanden sein. Es können sich beispielsweise in der zweiten ladungsträgertransportierenden Schicht auch zumindest zwei verschiedene phosphoreszierende Substanzen als Dopanten befinden.

Eine bevorzugte Ausführungsform umfasst eine zweite ladungsträgertransportierende Schicht, die phosphoreszierende Substanzen umfasst, die in unterschiedlichen Wellenlängen emittieren. Die zweite ladungsträgertransportierende Schicht lässt sich hierbei in Teilbereiche aufteilen, von denen jede eine andere phosphoreszierende Substanz umfasst. Der der ersten ladungsträgertransportierenden Schicht am nächsten gelegene Teilbereich umfasst dabei die phosphoreszierende Substanz, welche Strahlung mit der kürzesten Wellenlänge emittiert. Die weiteren Teilbereiche umfassen andere phosphoreszierende Substanzen bei denen die Wellenlänge der von ihnen abgegebenen Strahlung mit zunehmenden Abstand von der ersten ladungsträgertransportierenden Schicht zunimmt.

Umfasst die zweite ladungsträgertransportierende Schicht beispielsweise zwei phosphoreszierende Substanzen, so lässt sie sich in zwei Teilbereiche aufteilen. Ein erster Teilbereich umfasst beispielsweise eine im grünen Bereich emittierende phosphoreszierende Substanz, ein zweiter Teilbereich eine im roten Bereich emittierende phosphoreszierende Substanz. Der erste Teilbereich ist dann näher an der ersten ladungsträgertransportierenden Schicht angeordnet als der zweite Teilbereich.

Eine weitere bevorzugte Ausführungsform, umfasst mindestens zwei zweite ladungsträgertransportierende Schichten mit unterschiedlichen Matrixmaterialien. Die phosphoreszierenden Substanzen dieser Schichten emittieren Strahlung mit unterschiedlichen Wellenlängen. Hierbei sind die zweiten ladungsträgertransportierenden Schichten so angeordnet, dass die Wellenlänge der von den phosphoreszierenden Substanzen emittierten Strahlung mit zunehmenden Abstand von der ersten ladungsträgertransportierenden Schicht zunimmt.

So umfasst eine Ausführungsform beispielsweise zwei zweite ladungsträgertransportierende Schichten, wobei die eine zweite ladungsträgertransportierende Schicht eine im grünen Bereich phosphoreszierende Substanz und die andere zweite ladungsträgertransportierende Schicht eine im roten Bereich phosphoreszierende Substanz umfasst. Die eine zweite ladungsträgertransportierende Schicht mit dem grünen Emitter ist dann näher an der ersten ladungsträgertransportierenden Schicht angeordnet als die andere erste ladungsträgertransportierende Schicht mit dem roten Emitter.

In einer weiteren Ausführungsform sind die HOMO/LUMO-Niveaus der zweiten ladungsträgertransportierenden Schicht so auf die HOMO/LUMO-Niveaus der ersten ladungsträgertransportierenden Schicht abgestimmt, dass keine Ladungsträger erster Ladung in die zweite ladungsträgertransportierende Schicht gelangen können.

Des Weiteren können die HOMO/LUMO-Niveaus der zweiten ladungsträgertransportierenden Schicht so auf die HOMO/LUMO-Niveaus der ersten ladungsträgertransportierende Schicht abgestimmt sein, dass Triplettexcitonen von der ersten in die zweite ladungsträgertransportierende Schicht gelangen können. In einer weiteren Ausführungsform ist die Dicke der zweiten ladungsträgertransportierenden Schicht auf die Diffusionslänge der Triplettexcitonen abgestimmt, so dass die Triplettexcitonen durch die gesamte zweite ladungsträgertransportierende Schicht diffundieren können.

In einer weiteren Ausführungsform sind zumindest zwei zweite ladungsträgertransportierende Schichten vorhanden und die Gesamtdicke aller zweiten ladungsträgertransportierenden Schichten ist kleiner oder gleich groß wie die Diffusionslänge der Triplettexcitonen.

In einer weiteren Ausführungsform umfasst jede zweite ladungsträgertransportierende Schicht eine phosphoreszierende Substanz, welche bei einer anderen Wellenlänge emittiert.

In einer weiteren Ausführungsform sind die zweiten ladungsträgertransportierenden Schichten so angeordnet, dass die Wellenlänge der emittierten Strahlung mit größerem Abstand zur ersten ladungsträgertransportierenden Schicht zunimmt.

In einer weiteren Ausführungsform sind die HOMO/LUMO-Niveaus aller zweiten ladungsträgertransportierenden Schichten so aufeinander abgestimmt, dass von der ersten ladungsträgertransportierenden Schicht ein Excitonentransfer durch alle ladungsträgertransportierenden Schichten erfolgen kann.

In einer weiteren Ausführungsform verläuft ein Ladungsträgertransportpfad zum Transport der ersten und zweiten Ladungsträger während des Betriebs durch die Vorrichtung und der Ladungsträgertransportpfad für die ersten Ladungsträger ist auf den durch die erste Elektrode und die erste ladungsträgertransportierende Schicht begrenzten Bereich der Vorrichtung beschränkt und der Ladungsträgertransportpfad für die zweiten Ladungsträger verläuft mindestens durch die zweite ladungsträgertransportierende Schicht und die erste ladungsträgertransportierende Schicht.

Ein weiterer Aspekt ist auch der gewünschte Farbton, welche die Vorrichtung, z.B. die OLED abstrahlen soll, d.h. die Summe der Spektren der fluoreszierenden und phosphoreszierenden Substanzen. Durch die Variation der Abfolge der einzelnen Schichten, welche die phosphoreszierenden oder fluoreszierenden Dopanten beinhalten, wird der Anteil der Strahlung beeinflusst, welche von den einzelnen Dopanten zum Gesamtspektrum beigetragen wird. Wobei hier nicht nur die Lage, sondern auch die Dicke der jeweiligen Schicht eine Rolle spielt, wie auch die Dichte mit der der Dopant in die Matrixschicht eingebracht wird. Je näher die zweite ladungsträgertransportierende Schicht mit der phosphoreszierenden Substanz als z. B. Dopant an der ersten ladungsträgertransportierenden Schicht, der excitonenbildenden Schicht, gelegen ist, je besser die Energieübertragung vom Matrixmaterial auf den Dopant erfolgt, je dicker das Matrixmaterial ist und je höher der Anteil des Dopanten in der Matrix ist, desto größer ist der Beitrag der Emission dieses Dopanten zum Gesamtspektrum der OLED. In dem Fall, dass die zweite ladungsträgertransportierende Schicht überwiegend oder sogar ausschließlich aus der phosphoreszierenden Substanz gefertigt wurde, so sind deren Lage in der Schichtfolge und ihre Schichtdicke maßgebend für den Anteil, den die Emission aus dieser Schicht an der Gesamtemission der strahlungsemittierenden Vorrichtung hat.

Eine weitere Ausführungsform einer erfindungsgemäßen OLED umfasst mindestens zwei ladungsträgertransportierende Schichten wobei die erste ladungsträgertransportierende Schicht selbst ein fluoreszierendes Material umfasst oder mit einem fluoreszierenden Material dotiert wurde. Bei der Fluoreszenz handelt es sich um sichtbare Strahlung, die durch die Relaxation aus einem angeregten Singulettzustand in den Grundzustand abgegeben wird. Die zweite ladungsträgertransportierende Schicht enthält eine phosphoreszierende Substanz. Bei der Phosphoreszenz handelt es sich um sichtbare Strahlung, die durch Relaxation aus einem angeregten Triplettzustand in den Grundzustand abgegeben wird.

Die zweite ladungsträgertransportierende Schicht ist im wesentlichen frei von Ladungsträgern erster Ladung und transportiert nur Ladungsträger zweiter Ladung. Es erfolgt in der zweiten ladungsträgertransportierenden Schicht deshalb keine Rekombination von Elektroden und Löchern und somit erfolgt in dieser Schicht auch keine Bildung von Excitonen. Dies hat zur Folge, dass die phosphoreszierende Substanz in dieser Schicht nicht durch Energie angeregt werden kann, die von Excitonen stammt, welche in dieser Schicht gebildet wurden. Dies bedeutet wiederum dass die phosphoreszierende Substanz nur durch Energie angeregt werden kann, welche aus einer anderen Schicht in die Schicht übertragen wurde, in der sich die phosphoreszierende Substanz befindet. Dieser Energietransport kann beispielsweise über den sogenannten Dextertransfer-Mechanismus oder den Förstertransfer-Mechanismus erfolgen. Beim Dextertransfer-Mechanismus handelt es sich um einen Elektronenaustausch-Mechanismus über überlappende Orbitale bzw. Wellenfunktionen zwischen verschiedenen Molekülen, z. B. einer fluoreszierenden Substanz und dem Matrixmaterial. Um Elektronen austauschen zu können benötigen die Moleküle, zwischen denen der Elektronenaustausch erfolgen soll passende Redoxpotentiale. Beim Förstertransfer-Mechanismus ist eine Dipol-Dipol-Wechselwirkung für den Energietransfer verantwortlich. Hierzu müssen die beiden Moleküle eine spektrale Überlappung aufweisen. Über den Förstermechanismus kann nach Erkenntnis der Erfinder die Energie aber nur von einem Singulettzustand auf einen anderen Singulettzustand übertragen werden, wohingegen über den Dextermechanismus die Energie auch von einem Triplettzustand zu einem anderen Triplettzustand erfolgen kann, da hier nur das Gesetz der Spinerhaltung eingehalten werden muss.

Aufgrund der erfindungsgemäßen Kombination von fluoreszierenden Substanzen (Singulettemittern) und phosphoreszierenden Substanzen (Triplettemitter), in Schichten zwischen denen einen Energieübertragung möglicht ist, kann eine deutlich höhere Strahlungsausbeute erzielen werden, als es mit Singulettemittern und Triplettemittern möglich ist, welche in Schichten liegen zwischen denen kein Energietransfer erfolgt. Die räumliche Trennung von Singulett- und Triplettemittern sorgt zusätzlich dafür, dass zwischen den beiden Systemen keine strahlungslosen Quenchvorgänge möglich sind. Vorteilhaft ist auch die spektrale Erweiterung des Gesamtemissionsspektrums der Vorrichtung. Aufgrund des Überführens der ansonsten als Wärmestrahlung abgegebenen Energie der Triplettexcitonen in sichtbare Triplettemission resultiert eine erhöhte Lebensdauer der Vorrichtung auf Grund der Reduktion der Wärmestrahlung.

Im folgenden werden Substanzen angeführt, die sich zur Herstellung einer erfindungsgemäßen Vorrichtung eignen. Diese Aufzählung ist als Nennung von möglichen Beispielen und nicht als abschließende Auflistung zu sehen.
Für die löcherinjizierende Schicht (HIL) eignen sich beispielsweise folgende Materialien oder Kombinationen von Materialen:
Eine Matrix plus F4-TCNQ (Tetrafluoro-tetracyanochinolin) oder Derivate davon und Molybdän-Oxide.

Für die löchertransportierende Schicht (HTL) eignen sich beispielsweise folgende Materialien:
1-TNATA (4,4',4''-Tris(N-(naphth-1-yl)-N-phenyl-amino)triphenylamin, 2-TNATA (4,4',4''-Tris(N-(naphth-2-yl)-N-phenyl-amino)triphenylamin, MTDATA (4,4',4''-Tris(N-3-methylphenyl-N-phenyl-amino)Triphenylamin), aNPB (N,N'-Bis(naphthalen-1-yl)-N,N'-bis(phenyl)benzidin), bNPD (N,N'-Bis(naphthalen-2-yl)-N,N'-bis(phenyl)benzidin), TPD (N,N'-Bis(3-methyphenyl)-N,N'-bis(phenyl)bezidin), spTAD (2,2',7,7'-Diphenylamino-spiro-9,9'-bifluoren), Cu-PC (Phthalocyanin-Kupfer-Komplex) oder andere PC-MetallKomplexe, TAPC (1,1-Bis-[(4-phenyl-)-bis-(4',4''-methylphenyl)-amino]-cyclohexan).

Für die elektronentransportierende Schicht (ETL) eignen sich beispielsweise folgende Materialien:
Alq3 (Tris(8-hydroxyquinoline)aluminium, BAlq2 (Bis-[2-methyl-8-quinolato]-[4-phenylphenolato]-aluminium (III)), BPhen (4,7-Diphenyl-1,10-phenanthrolin), BCP (2,9-Dimethyl-4,7-diphenyl-1,10-phenanthrolin), OXD7, OXD8, TPBi (1,3,5-Tris-(1-phenyl-1H-benzimidatol-2-yl)-benzen), TAZ (3-(4-Biphenyl)-4-phenyl-5-(4-tert-butylphenyl)-1,2,4-triazol), TAZ2 (3,5-Diphenyl-4-naphth-1-yl-1,2,4-triazol), t-Bu-PBD (2-(-Biphenyl)-5-(4-tert-butyl-phenyl)-1,3,4-oxadiazol), Triazin oder Triazinderivate.

Als phosphoreszierende Substanz eignen sich beispielsweise folgende phosphoreszierenden Materialien oder Kombinationen von Materialen:
FIr6, FPt1 ([2-(4',6'-Difluorophenyl)-pyridinato)-acetylacetonat]-platinium-II), FIrpic (Bis(3,5-difluoro-2-(2-pyridyl)phenyl-(2-carboxypyridyl)-iridium-III), FIrN4, Irppy3 (fac-Tris(2-phenyl-pyridyl)iridium Komplex), Ir(ppy)2acac, Ir(typ)3 (Tris[2-(4-totyl)-pyridinato]-iridium(III)), Ir(typ)2acac, Ir(bt)2acac, Ir(btp)2acac (Bis[2-(2'-benzothienyl-pyridinato]-[acetyl-acetonato]-iridium(III)), Ir(dbp)2acac (Iridium(III)bis(dibenzo-[f,h]quinoxalin)(acetylacetonat)), Ir(mdp)2acac (Iridium(III)bis(2-methyldibenzo-[f,h]quinoxalin)(acetylacetonat)), Ir(pq)3, Ir(pq)2acac, Ir(piq)3, (CF3ppy)2Ir(pic), PtOEP (Platiniumoctaethylporphyrin).

Für die Schicht oder als Matrixmaterial, in dem sowohl die fluoreszierende als auch phosphoreszierende Substanz eingelagert werden können eignen sich beispielsweise folgende Materialien oder Kombinationen von Materialen:
CBP (4,4'-Bis(carbazol-9-yl)-2-2'dimethyl-biphenyl), TCTA (4,4',4''-Tris(n-(naphth-2-yl)-N-phenyl-amino)triphenylamin), mCP, TCP (1,3,5-Tris-carcazol-9-yl-bezen), CPF, CDBP (4,4'-Bis(carbazol-9-yl)-2,2'-dimethyl-biphenyl), DPVBi (4,4-Bis(2,2-diphenyl-ethen-1-yl)-diphenyl), Spiro-PVBi (spiro-4,4'-Bis(2,2-diphenyl-ethen-1-yl)-diphenyl), UGH1, UGH2, UGH3, UGH4, CzSi, ADN (9,10-Di(2-naphthyl)anthracen), TBADN, MADN, Perylen, Carbazolderivate, Fluorenderivate.

Als fluoreszierende Substanz eignen sich beispielsweise folgende Materialien oder Kombinationen von Materialen:
DCM (4-(Dicyanomethylen)-2-methyl-6-(p-dimethylamino-styryl)4H-pyran), DCM2 (4-(Dicyanomethylen)-2-methyl-6-(julolidin-4-yl-vinyl)-4H-pyran), DCJTB, Rubren (5,6,11,12-Tetraphenyl-naphthacen), Coumarin (C545T), BCzVBi, BCzVb, TBSA (9,10-Bis[(2",7""-di-t-butyl)-9',9''-spirobifluorenyl]anthracen), DPAVBi, DPAVB, Zn-Komplexe, Cu-Komplexe.

Im folgenden sollen Varianten der Erfindung anhand von Figuren und Ausführungsbeispielen näher erläutert werden.
Figur 1 zeigt eine schematische Seitenansicht einer Ausführungsform einer strahlungsemittierenden Vorrichtung.
Figur 2 zeigt eine schematische Seitenansicht einer möglichen weiteren Ausführungsform einer strahlungsemittierenden Vorrichtung.
Figur 3 zeigt eine schematische Seitenansicht einer möglichen weiteren Ausführungsform einer strahlungsemittierenden Vorrichtung.
Figur 4 zeigt eine schematische Seitenansicht einer speziellen Ausführungsform einer strahlungsemittierenden Vorrichtung.

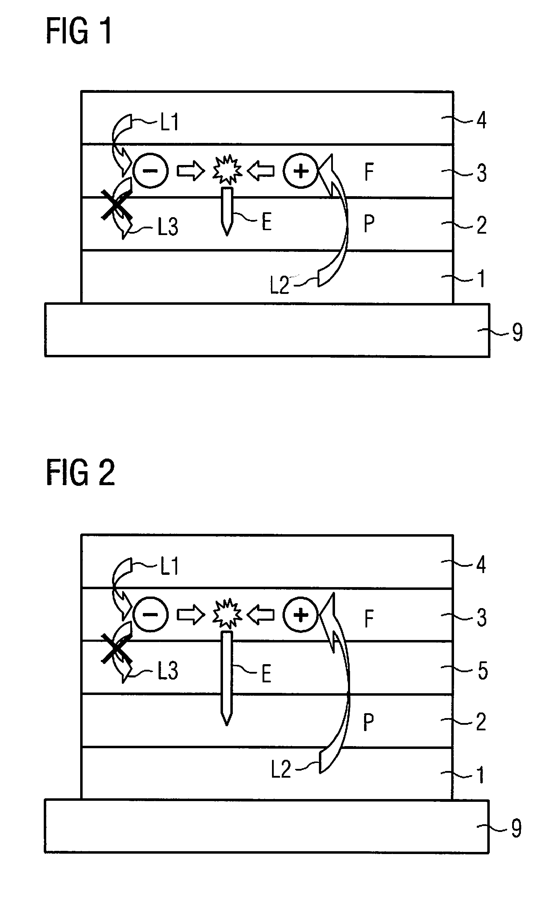

Figur 1 zeigt eine schematische Seitenansicht einer Ausführungsform der strahlungsemittierenden Vorrichtung. Diese umfasst die fünf dargestellten Schichten. Hierbei ist die unterste Schicht 9 ein Substrat, die darauffolgende Schicht 1 die Anode. Schicht 2 ist eine zweite ladungsträgertransportierende Schicht, eine unipolare löchertransportierende Schicht, die keine Elektronen transportieren kann oder Elektronen blockt. Darauf angeordnet ist die erste ladungsträgertransportierende Schicht 3, die sowohl Elektronen wie auch Löcher transportiert und damit ambipolar ist. Die Kathode wird durch Schicht 4 dargestellt. Die zweite ladungsträgertransportierende Schicht 2 enthält die phosphoreszierende Substanz P, die erste ladungsträgertransportierende Schicht 3 die fluoreszierende Substanz F. Die Elektronen, schematisch als eingekreiste Minuszeichen dargestellt, werden von der Kathode 4 in die erste ladungsträgertransportierende Schicht 3 injiziert, schematisch dargestellt durch den Pfeil L1. Aus dieser können sie nicht weiter in die zweite ladungsträgertransportierende Schicht 2 diffundieren, da diese Elektronen blockt oder nicht transportieren kann, schematisch dargestellt durch den durchgestrichenen Pfeil L3. Die Löcher, schematisch als eingekreiste Pluszeichen dargestellt, die von der Anode 1 in die zweite ladungsträgertransportierende Schicht 2 injiziert werden, werden von der zweiten ladungsträgertransportierenden Schicht 2 in die erste ladungsträgertransportierende Schicht 3 transportiert schematisch dargestellt durch den Pfeil L2. Die in der ersten ladungsträgertransportierenden Schicht 3 durch Rekombination von Elektronen und Löchern gebildeten Excitonen, schematisch als Stern dargestellt, können in die zweite ladungsträgertransportierende Schicht 2 diffundieren, bzw. die Energie, schematisch dargestellt durch den Pfeil E, über Energietransfermechanismen in die zweite ladungsträgertransportierende Schicht 2 übertragen werden, und dort die phosphoreszierenden Substanz P zum Phosphoreszieren anregen. Da die zweite ladungsträgertransportierende Schicht 2 weitgehend frei von Elektronen ist, kann in dieser Schicht keine Rekombination von Elektronen und Löchern und somit auch keine Bildung von Excitonen stattfinden. Die in der ersten ladungsträgertransportierenden Schicht 3 befindliche fluoreszierende Substanz F wird ebenfalls durch die Energie der Excitonen, welche in dieser Schicht gebildet werden, über Energietransfermechanismen angeregt. Somit werden unterschiedliche elektrolumineszierende Substanzen (F und P), die in unterschiedlichen Schichten (3 und 2) angeordnet sind, durch Energie von Excitonen elektronisch angeregt, wobei die Energie aus der ersten ladungsträgertransportierenden Schicht 3 stammt.

Figur 2 zeigt eine schematische Seitenansicht einer weiteren Ausführungsform der strahlungsemittierenden Vorrichtung. Diese umfasst sechs dargestellte Schichten. Hierbei ist die unterste Schicht 9 ein Substrat, die darauffolgende Schicht 1 die Anode. Schicht 2 ist die zweite ladungsträgertransportierende Schicht, eine löchertransportierende Schicht. Die Schicht 5 stellt eine erste ladungsträgerblockende Schicht, hier eine Elektronen blockierende Schicht dar. Darauf angeordnet ist die erste ladungsträgertransportierende Schicht 3 eine Schicht die sowohl Elektronen wie auch Löcher transportiert. Die Kathode wird durch Schicht 4 dargestellt. Die zweite ladungsträgertransportierende Schicht 2 enthält die phosphoreszierende Substanz P und die erste ladungsträgertransportierende Schicht 3 die fluoreszierende Substanz F. Die Elektronen, schematisch als eingekreiste Minuszeichen dargestellt, werden von der Kathode 4 in die erste ladungsträgertransportierende Schicht 3 injiziert. Aus dieser können sie nicht weiter in die Schicht 5 diffundieren, da diese Elektronen blockt, schematisch dargestellt durch den durchgestrichenen Pfeil L3. Die Löcher, schematisch als eingekreiste Pluszeichen dargestellt, die von der Kathode in die zweite ladungsträgertransportierende Schicht 2 injiziert werden, werden von der zweiten ladungsträgertransportierenden Schicht 2 durch die Schicht 5 in die erste ladungsträgertransportierende Schicht 3 transportiert, schematisch dargestellt durch den Pfeil L2. Die in der ersten ladungsträgertransportierenden Schicht 3 durch Rekombination von Elektronen und Löchern gebildeten Excitonen, schematisch als Stern dargestellt, können durch die Schicht 5 in die zweite ladungsträgertransportierende Schicht 2 diffundieren, bzw. die Energie, schematisch dargestellt durch den Pfeil E, über Energietransfermechanismen in die zweite ladungsträgertransportierende Schicht 2 übertragen werden, und dort die phosphoreszierende Substanz P zum Phosphoreszieren anregen. Die Schicht 5 blockiert die Ladungsträger erster Ladung, hier die Elektronen, so dass die Schicht 2 weitgehend frei von Elektronen ist. So kann in der zweiten ladungsträgertransportierenden Schicht 2 keine Rekombination von Elektronen und Löchern stattfinden und somit keine Bildung von Excitonen. Die räumliche Trennung zwischen der die phosphoreszierende Substanz P enthaltenden Schicht 2 und der die fluoreszierende Substanz F enthaltenden ersten ladungsträgertransportierenden Schicht 3, ist in der in Figur 2 dargestellten Ausführungsform nochmals größer, als in der in Figur 1 dargestellten Ausführungsform, in der die Schichten 2 und 3 direkt benachbart sind.

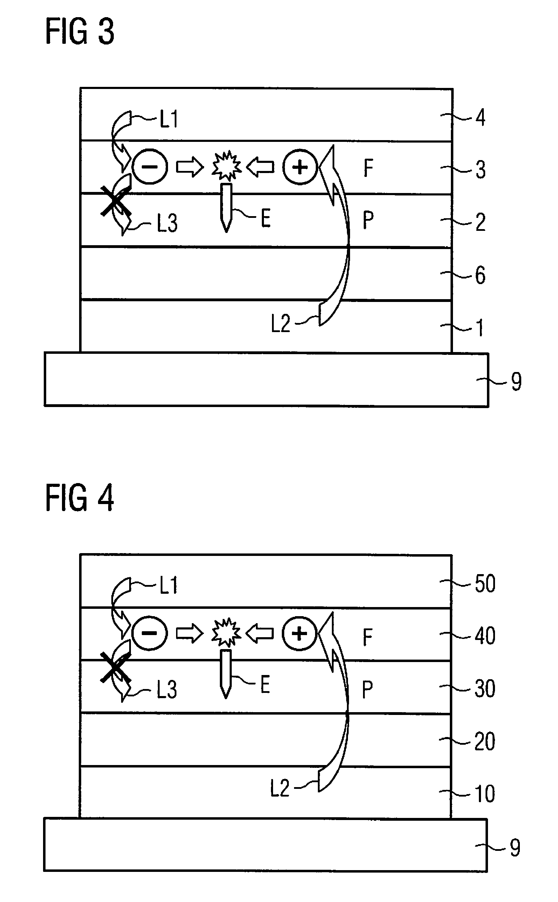

Figur 3 zeigt eine schematische Seitenansicht einer weiteren Ausführungsform der strahlungsemittierenden Vorrichtung. Diese umfasst die sechs dargestellten Schichten. Hierbei ist die unterste Schicht 9 ein Substrat, die darauffolgende Schicht 1 die Anode. Schicht 6 stellt eine Excitonen blockierende Schicht dar. Schicht 2 ist die zweite ladungsträgertransportierende Schicht, eine löchertransportierende Schicht, die Elektronen nicht oder nur im untergeordneten Maße transportiert. Auf der löchertransportierenden Schicht 2 ist die erste Ladungsträger transportierende Schicht 3, die sowohl Elektronen wie auch Löcher transportiert, angeordnet. Die Kathode wird durch Schicht 4 dargestellt. Die zweite ladungsträgertransportierende Schicht 2 enthält die phosphoreszierende Substanz P, die erste ladungsträgertransportierende Schicht 3 die fluoreszierende Substanz F. Die Elektronen, schematisch als eingekreiste Minuszeichen dargestellt, werden von der Kathode 4 in die erste ladungsträgertransportierende Schicht 3 injiziert, schematisch dargestellt durch den Pfeil L1. Aus dieser können sie nicht weiter in die zweite ladungsträgertransportierende Schicht 2 diffundieren, da diese Elektronen blockt oder nicht transportieren kann, schematisch dargestellt durch den durchgestrichenen Pfeil L3 Die Löcher, schematisch als eingekreiste Pluszeichen dargestellt, die von der Anode 1 in die excitonenblockende Schicht 6 injiziert werden, werden durch die zweite ladungsträgertransportierende Schicht 2 in die erste ladungsträgertransportierende Schicht 3 transportiert, schematisch dargestellt durch den Pfeil L2. Die in der ersten ladungsträgertransportierenden Schicht 3 durch Rekombination von Elektronen und Löchern gebildeten Excitonen, schematisch als Stern dargestellt, können in die zweite ladungsträgertransportierende Schicht 2 diffundieren, bzw. die Energie, schematisch dargestellt durch den Pfeil E, über Energietransfermechanismen in die zweite ladungsträgertransportierende Schicht 2 übertragen werden, und dort die phosphoreszierenden Substanz P zum Phosphoreszieren anregen. Da die zweite ladungsträgertransportierende Schicht 2 weitgehend frei von Elektronen ist, kann in dieser Schicht keine Rekombination stattfinden und somit keine Bildung von Excitonen. Durch die Schicht 6 können die Excitonen, aus der ersten ladungsträgertransportierenden Schicht 3 kommend, nicht durch die zweite ladungsträgertransportierende Schicht 2 hindurch in darauffolgende Schichten, beispielsweise in Richtung der Anode diffundieren, da Schicht 6 Excitonen blockiert. Somit wird das strahlungslose Quenchen der Excitonen an der Anode verhindert bzw. vermindert. Die Energie der Excitonen, vor allem der Triplettexcitonen kann somit zu großen Teilen von der phosphoreszierenden Substanz P der zweiten ladungsträgertransportierenden Schicht 2 aufgenommen werden, was die Strahlungsausbeute der Vorrichtung steigert.

Figur 4 zeigt eine schematische Seitenansicht einer weiteren Ausführungsform der strahlungsemittierenden Vorrichtung, einer OLED. Die sechs dargestellten Schichten stehen für folgende Bestandteile der Erfindung. Schicht 9 stellt ein Substrat dar, auf dem die weiteren Schichten aufgebracht sind. Schicht 10 ist eine transparente Anode. 20 ist eine löcherinduzierende Schicht (HIL), welche die Energiebarriere für den Löchertransfer von der Anode in die löchertransportierende Schicht herabsetzt. 30 ist eine löchertransportierende Schicht (HTL), die eine phosphoreszierende Substanz P enthält. 40 ist eine sowohl Elektronen wie auch Löcher transportierende Schicht, welche eine fluoreszierende Substanz F umfasst. Die Schicht 50 stellt die Kathode dar.

Eine bevorzugte Ausführungsform ist eine OLED mit dem Aufbau wie er in Figur 4 schematisch dargestellt ist. Die OLED ist aus folgenden Schichten aufgebaut: ITO/PEDOT/HTL/LEP/Kathode. Wobei ITO (Indiumzinnoxid) die transparente Anode 10 ist, PEDOT die löcherinduzierende Schicht 20 und HTL eine löchertransportierende Schicht 30 ist. LEP steht für eine Licht emittierende Schicht 40, wobei die Schicht 40 Licht in Form von Fluoreszenz emittiert. Die Kathode aus Aluminium (200 nm) mit einer dünnen Schicht CsF (1 nm) wird durch die Schicht 50 dargestellt. In diesem Ausführungsbeispiel ist die LEP 40 ein Polymer, welches im blauen Bereich fluoresziert. Die HTL 30 enthält eine phosphoreszierende Substanz P, welche in rotem Bereich phosphoresziert, also ebenfalls Licht emittiert. Das Material der HTL 30 ist so gewählt, das zwar Löcher aber keine Elektronen transportiert werden. Das heißt ein Zusammentreffen von Elektronen und Löchern und somit eine Rekombination ist nur in der LEP 40 möglich. Ein Teil der durch die Rekombination von Elektronen und Löchern freigesetzten Energie regt nun das in dieser Schicht befindliche Polymer in den Singulettzustand an, aus welchem dieses dann unter Aussendung von Licht im blauen Wellenlängenbereich emittiert. Ein anderer Teil der Energie, vor allem die Triplettexcitonen wird über Energietransferprozesse in die HTL 30 transportiert, in der sich die phosphoreszierende Substanz P befindet. Dieser wird durch die aus der LEP 40 überführten Energie in ein Triplettniveau angeregt, aus dem die phosphoreszierende Substanz P dann unter Abgabe von Strahlung im sichtbaren Bereich relaxiert.

Das Spektrum einer solchen OLED weist neben den Banden des Fluoreszenzlichtes noch ein in der Regel zu längeren Wellenlängen erweitertes Spektrum durch die zusätzliche Phosphoreszenzemission auf. Durch eine entsprechende Wahl der Materialien kann eine solche OLED weißes Licht erzeugen.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Strahlungsemittierende Vorrichtung umfassend,
- eine erste Elektrode (4), die im Betrieb erste Ladungsträger mit einer ersten Ladung abgibt,
- eine erste ladungsträgertransportierende Schicht (3), die eine fluoreszierende Substanz umfasst und auf der ersten Elektrode angeordnet ist,
- eine zweite ladungsträgertransportierende Schicht (2), die eine phosphoreszierende Substanz enthält und auf der ersten ladungsträgertransportierenden Schicht angeordnet ist,
- eine zweite Elektrode (1), die im Betrieb zweite Ladungsträger mit einer zweiten Ladung abgibt und auf der zweiten ladungsträgertransportierenden Schicht angeordnet ist,
- wobei die zweite ladungsträgertransportierende Schicht (2) im Betrieb weitgehend frei ist von ersten Ladungsträgern, welche von der ersten Elektrode (4) abgegeben werden.

2. Strahlungsemittierende Vorrichtung nach dem vorhergehenden Anspruch,
- bei der die zweite ladungsträgertransportierende Schicht (2) unipolar ist und nur zweite Ladungsträger transportieren kann, oder erste Ladungsträger blockiert.

3. Strahlungsemittierende Vorrichtung nach einem der vorhergehenden Ansprüche,
wobei zwischen der ersten ladungsträgertransportierenden Schicht (3) und der zweiten ladungsträgertransportierenden Schicht (2) eine unipolare ladungsträgertransportierende Schicht (5) angeordnet ist, die die Ladungsträger erster Ladung blockiert oder nur Ladungsträger zweiter Ladung transportieren kann.

4. Strahlungsemittierende Vorrichtung nach einem der vorhergehenden Ansprüche, ausgebildet als organische Leuchtdiode (OLED),
wobei die erste ladungsträgertransportierende Schicht (3), die zweite ladungsträgertransportierende Schicht (2), die phosphoreszierende Substanz oder die fluoreszierende Substanz organische Materialien umfassen.

5. Strahlungsemittierende Vorrichtung nach einem der vorhergehenden Ansprüche,
wobei durch die Rekombination von Ladungsträgern erster Ladung und Ladungsträgern zweiter Ladung Excitonen als angeregte elektronische Zustände gebildet werden können, die Singulett- und Triplettexcitonen umfassen.

6. Strahlungsemittierende Vorrichtung nach dem vorhergehenden Anspruch,
wobei nur in der ersten ladungsträgertransportierenden Schicht (2) eine Rekombination von Ladungsträgern erster Ladung und Ladungsträgern zweiter Ladung stattfindet.

7. Strahlungsemittierende Vorrichtung nach Anspruch 5,
- bei der die in der ersten ladungsträgertransportierenden Schicht gebildeten Excitonen Triplettexcitonen umfassen und
- bei der die phosphoreszierende Substanz bei Anregung durch die Energie der in der ersten ladungsträgertransportierenden Schicht gebildeten Triplettexcitonen phosphoreszierende Strahlung emittiert.

8. Strahlungsemittierende Vorrichtung nach einem der vorhergehenden Ansprüche, bei der
- die erste Elektrode (4) eine Anode ist,
- die erste ladungsträgertransportierende Schicht (3) eine lochtransportierende und elektronentransportierende Schicht ist,
- die zweite ladungsträgertransportierende Schicht (2) eine elektronentransportierende Schicht ist,
- die zweite Elektrode (1) eine Kathode ist.

9. Strahlungsemittierende Vorrichtung nach Anspruch 8,
wobei die zweite ladungsträgertransportierende Schicht (2) eine Löcher blockierende, oder ausschließlich Elektronen transportierende Schicht ist.

10. Strahlungsemittierende Vorrichtung nach einem der Ansprüche 1 bis 7, bei der
- die erste Elektrode (1) eine Kathode ist,
- die erste ladungsträgertransportierende Schicht (3) eine lochtransportierende und elektronentransportierende Schicht ist,
- die zweite ladungsträgertransportierende Schicht (2) eine lochtransportierende Schicht ist,
- die zweite Elektrode (1) eine Anode ist.

11. Strahlungsemittierende Vorrichtung nach Anspruch 10,
wobei die zweite ladungsträgertransportierende Schicht (2) eine Elektronen blockierende oder ausschließlich lochtransportierende Schicht ist.

12. Strahlungsemittierende Vorrichtung nach einem der vorhergehenden Ansprüche,
wobei sich zwischen der zweiten ladungsträgertransportierenden Schicht (2) und der zweiten Elektrode (1) eine excitonenblockende Schicht (6) befindet.

13. Strahlungsemittierende Vorrichtung nach einem der vorhergehenden Ansprüche,
bei dem die fluoreszierende Substanz ein organisches Material umfasst.

14. Strahlungsemittierende Vorrichtung nach einem der vorhergehenden Ansprüche,
bei dem die fluoreszierende Substanz als Dopant in einem ladungsträgertransportierenden Matrixmaterial vorhanden ist.

15. Strahlungsemittierende Vorrichtung nach einem der vorhergehenden Ansprüche,
bei dem die phosphoreszierende Substanz ein organisches Material umfasst.
